# FASCICULE DE BREVET EUROPEEN

(11) **EP 4 432 358 B1**
(45) Date de publication et mention de la délivrance du brevet: **14.05.2025**
(21) Numéro de dépôt: 24161327.2
(22) Date de dépôt: 05.03.2024
(51) Int. Cl.: H10D 89/60

(54) **DISPOSITIF DE PROTECTION CONTRE DES DECHARGES ELECTROSTATIQUES**
SCHUTZVORRICHTUNG GEGEN ELEKTROSTATISCHE ENTLADUNGEN
ELECTROSTATIC DISCHARGE PROTECTION DEVICE

(30) Priorité: 17.03.2023 FR 2302482
(43) Date de publication de la demande: 18.09.2024
(73) Titulaire: STMicroelectronics International N.V., 1228 Plan-les-Ouates, Geneva (CH)
(72) Inventeur: GUITTON, Fabrice, 37380 MONNAIE (FR)
(74) Mandataire: Cabinet Beaumont

(56) Documents cités:
- EP-A1- 0 148 577
- US-A1- 2014 198 417
- US-A1- 2021 242 195

## Description

### Domaine technique

La présente description concerne de façon générale les dispositifs électroniques, et plus particulièrement les dispositifs de protection contre des décharges électrostatiques.

### Technique antérieure

Les décharges électrostatiques peuvent produire, dans des circuits intégrés ou des composants électroniques qui les subissent, des effets délétères susceptibles de provoquer une détérioration irréversible de tout ou partie de leurs éléments constitutifs. Un circuit intégré ou un composant électronique peut ainsi souffrir de dysfonctionnements importants, voire être rendu totalement inopérant, suite à une décharge électrostatique. Le cas échéant, un remplacement du circuit ou du composant défectueux peut s'avérer nécessaire, nuisant ainsi à la fiabilité d'appareils électroniques intégrant de tels circuits ou composants.

Afin de se prémunir contre les conséquences néfastes des décharges électrostatiques, les circuits intégrés et les composants électroniques peuvent comporter des dispositifs de protection. Toutefois, les dispositifs de protection contre des décharges électrostatiques existants souffrent de divers inconvénients. En particulier, la présence d'un dispositif de protection peut entraver le fonctionnement d'autres circuits ou composants voisins de ce dispositif.

US 2021/0242195 A1, US 2014/0198417 A1 and EP 0 148 577 A1 décrivent des dispositifs de protection contre des décharges électrostatiques.

### Résumé de l'invention

Il existe un besoin d'améliorer les dispositifs de protection contre des décharges électrostatiques existants. Il existe notamment un besoin de réduire des perturbations causées par la présence d'un dispositif de protection contre des décharges électrostatiques dans un appareil électronique.

Pour cela, la revendication 1 de l'invention prévoit un dispositif pseudo-bidirectionnel de protection contre des décharges électrostatiques, comprenant :
- des première et deuxième diodes reliant respectivement des première et deuxième bornes à un même nœud interne du dispositif ; et
- une troisième diode reliant le nœud interne à une troisième borne d'application d'un potentiel de référence, dans lequel la troisième diode présente une capacité supérieure à celle des première et deuxième diodes, le dispositif comportant en outre des premier et deuxième éléments capacitifs connectés respectivement en parallèle des première et deuxième diodes.

Selon un mode de réalisation :
- la première diode comprend des électrodes d'anode et de cathode connectées respectivement au nœud interne et à la première borne ; et
- la deuxième diode comprend des électrodes d'anode et de cathode connectées respectivement au nœud interne et à la deuxième borne.

Selon un mode de réalisation, la troisième diode comprend des électrodes d'anode et de cathode connectées respectivement au nœud interne et à la troisième borne.

Selon un mode de réalisation, les premier et deuxième éléments capacitifs sont des condensateurs.

Selon un mode de réalisation, le dispositif présente une structure monolithique.

Selon un mode de réalisation, les premier et deuxième éléments capacitifs sont des condensateurs MIM.

Selon un mode de réalisation, le dispositif comprend en outre :
- des troisième et quatrième éléments capacitifs, distincts des premier et deuxième éléments capacitifs, reliant respectivement les première et deuxième bornes à la troisième borne ; et
- des premier et deuxième éléments résistifs reliant respectivement les première et deuxième bornes à des quatrième et cinquième bornes.

Selon un mode de réalisation :
- les troisième et quatrième éléments capacitifs présentent chacun une capacité égale à environ 55 pF ; et
- les premier et deuxième éléments résistifs présentent chacun une résistance égale à environ 50 Ω.

Selon un mode de réalisation, les première, deuxième et troisième diodes sont des diodes Zener ou des diodes de suppression de tensions transitoires.

Selon un mode de réalisation, les premier et deuxième éléments capacitifs présentent des capacités sensiblement identiques entre elles.

Selon un mode de réalisation, les premier et deuxième éléments capacitifs présentent chacun une capacité égale à environ 10 pF.

Selon un mode de réalisation, la troisième diode présente une capacité au moins deux fois supérieure, de préférence au moins cinq fois supérieure, plus préférentiellement environ dix fois supérieure à celles des première et deuxième diodes.

Selon un mode de réalisation :
- les première et deuxième diodes présentent chacune une capacité égale à environ 4,5 pF ; et
- la troisième diode présente une capacité égale à environ 38 pF.

Selon un mode de réalisation, les première et deuxième bornes sont des bornes d'entrée et/ou de sortie d'un circuit intégré.

Selon un mode de réalisation, le nœud interne correspond à un substrat semiconducteur dans et sur lequel est formé le dispositif.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique illustrant un exemple de dispositif usuel de protection contre des décharges électrostatiques ;
la figure 2 est un schéma électrique illustrant un exemple de dispositif de protection contre des décharges électrostatiques selon un mode de réalisation ; et
la figure 3 est un schéma électrique illustrant un autre exemple de dispositif de protection contre des décharges électrostatiques selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les composants ou circuits intégrés susceptibles d'être protégés contre des décharges électrostatiques par les dispositifs de la présente description ne seront pas détaillés, les modes de réalisation décrits étant compatibles avec les composants ou circuits intégrés usuellement protégés contre des décharges électrostatiques.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

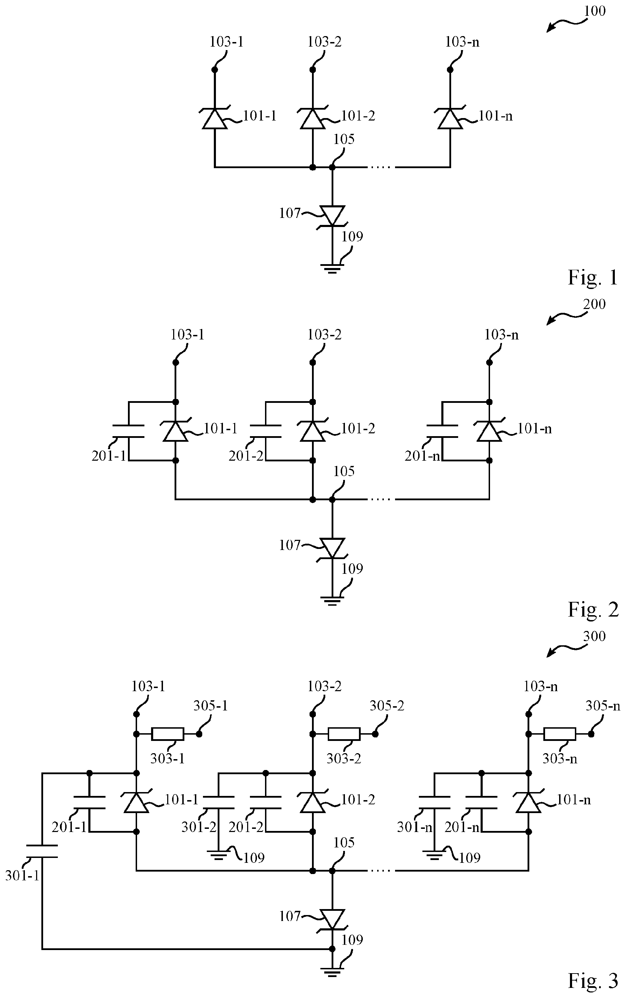

La figure 1 est un schéma électrique illustrant un exemple de dispositif 100 usuel de protection contre des décharges électrostatiques.

Dans l'exemple représenté, le dispositif 100 comprend plusieurs diodes 101-1, 101-2, ... 101-n reliant respectivement des bornes 103-1, 103-2, ... 103-n à un même nœud interne 105. Plus précisément, dans l'exemple illustré en figure 1, chaque diode 101-1, 101-2, ... 101-n comprend une électrode ou borne d'anode connectée au nœud interne 105, et une électrode ou borne de cathode connectée à la borne 103-1, 103-2, ... 103-n correspondante.

Les bornes 103-1, 103-2, ... 103-n sont par exemple des bornes d'entrée, des bornes de sortie ou des bornes d'entrée-sortie d'un circuit intégré ou d'un composant électronique à protéger contre des décharges électrostatiques. Chaque borne 103-1, 103-2, ... 103-n est par exemple adaptée à recevoir ou émettre un signal numérique ou analogique, par exemple un signal analogique présentant une fréquence inférieure à 10 ou 20 MHz. À titre d'exemple, les bornes 103-1, 103-2, ... 103-n sont, en fonctionnement nominal, soumises à un potentiel de l'ordre de 3,3 V, de l'ordre de 5 V ou de l'ordre de 15 V.

De manière générale, le dispositif 100 comprend n branches comprenant chacune une borne 103 reliée au nœud 105 par une diode 101, avec n un nombre entier supérieur ou égal à deux. Le nombre n est par exemple égal au nombre de bornes 103 externes d'un circuit intégré à protéger contre des décharges électrostatiques.

Dans l'exemple représenté, le dispositif de protection contre des décharges électrostatiques 100 comprend en outre une autre diode 107 reliant le nœud interne 105 à une autre borne 109 d'application d'un potentiel de référence, par exemple la masse. Plus précisément, dans l'exemple illustré en figure 1, la diode 107 comprend une électrode ou borne d'anode connectée au nœud interne 105, et une électrode ou borne de cathode connectée à la borne 109 d'application du potentiel de référence.

Le dispositif 100 de protection contre des décharges électrostatiques présente une architecture dite « pseudo-bidirectionnelle ». Cela se traduit notamment par le fait que les diodes 101-1, 101-2, ... 101-n connectées aux bornes 103-1, 103-2, ... 103-n ont leurs anodes connectées au même nœud 105 et par le fait qu'une seule diode 107 relie les anodes des diodes 101-1, 101-2, ... 101-n à la borne 109 d'application du potentiel de référence.

La diode 107 du dispositif 100 présente une capacité strictement supérieure, par exemple au moins deux fois supérieure, par exemple au moins cinq fois supérieure, par exemple environ dix fois supérieure à la capacité de chaque diode 101-1, 101-2, ... 101-n. Cela permet de réduire les phénomènes de diaphonie (« crosstalk » en anglais) entre les bornes 103-1, 103-2, ... 103-n. La capacité de chaque diode 101-1, 101-2, ... 101-n est par exemple de l'ordre de quelques picofarads, et la capacité de la diode 107 est par exemple de l'ordre de quelques dizaines de picofarads. Les diodes 101-1, 101-2, ... 101-n du dispositif 100 présentent par exemple des capacités sensiblement égales entre elles, aux dispersions de fabrication près. À titre d'exemple, chaque diode 101-1, 101-2, ... 101-n présente une capacité égale à environ 4,5 pF, et la diode 107 présente une capacité égale à environ 38 pF.

Dans l'exemple illustré, les diodes 101-1, 101-2, ... 101-n et 107 du dispositif 100 sont des diodes Zener. Cet exemple n'est toutefois pas limitatif, chaque diode 101-1, 101-2, ... 101-n, 107 du dispositif 100 pouvant, à titre de variante, être une diode de suppression de tensions transitoires (« Transient Voltage Suppression » - TVS, en anglais).

En cas de décharge électrostatique, une surtension positive ou négative peut apparaître entre l'une des bornes 103-1, 103-2, ... 103-n et la borne 109 d'application du potentiel de référence. À titre d'exemple, dans un cas où chaque borne 103-1, 103-2, ... 103-n est adaptée à être polarisée par une tension nominale égale à environ 3,3 V, une surtension positive peut correspondre à l'application, entre l'une des bornes 103-1, 103-2, ... 103-n et la borne 109, d'une tension de l'ordre de +10 V et une surtension négative peut correspondre à l'application, entre l'une des bornes 103-1, 103-2, ... 103-n et la borne 109, d'une tension de l'ordre de -10 V.

En cas de surtension positive entre l'une des bornes 103-1, 103-2, ... 103-n et la borne 109 du dispositif 100, la diode 101-1, 101-2, ... 101-n connectée à cette borne est polarisée en inverse par une tension supérieure à sa tension de claquage ou d'avalanche, et la diode 107 est polarisée en direct par une tension supérieure à sa tension de seuil. La diode 101-1, 101-2, ... 101-n laisse alors passer un courant inverse, et la diode 107 laisse passer un courant direct. Le courant résultant de la décharge électrostatique est ainsi évacué depuis la borne 103-1, 103-2, ... 103-n vers la borne 109.

En cas de surtension négative entre l'une des bornes 103-1, 103-2, ... 103-n et la borne 109 du dispositif 100, la diode 101-1, 101-2, ... 101-n connectée à cette borne est polarisée en direct par une tension supérieure à sa tension de seuil, et la diode 107 est polarisée en inverse par une tension supérieure à sa tension de claquage ou d'avalanche. La diode 101-1, 101-2, ... 101-n laisse alors passer un courant direct, et la diode 107 laisse passer un courant inverse. Le courant résultant de la décharge électrostatique est ainsi évacué depuis la borne 109 vers la borne 103-1, 103-2, ... 103-n.

Un inconvénient du dispositif 100 de protection contre des décharges électrostatiques tient au fait que sa présence génère des harmoniques sur les bornes 103-1, 103-2, ... 103-n, notamment des harmoniques de deuxième et de troisième rang.

Afin de réduire la production d'harmoniques, une solution pourrait consister à substituer le dispositif 100 pseudo-bidirectionnel par un dispositif de protection contre des décharges électrostatiques présentant une structure de type entièrement bidirectionnelle. Dans un tel dispositif, les anodes des n diodes 101-1, 101-2, ... 101-n sont par exemple connectées respectivement à des anodes de n autres diodes dont les cathodes sont connectées à la borne 109 d'application du potentiel de référence. En d'autres termes, un dispositif entièrement bidirectionnel comprend autant de diodes 101 dont les cathodes sont respectivement connectées aux bornes 103 que de diodes dont les cathodes sont connectées à la borne 109, chaque borne 103 étant ainsi reliée à la borne 109 par une association en série de deux diodes interconnectées par leurs cathodes. Un dispositif entièrement bidirectionnel présenterait toutefois un encombrement et un coût supérieurs à ceux du dispositif 100 pseudo-bidirectionnel.

La figure 2 est un schéma électrique illustrant un exemple de dispositif 200 de protection contre des décharges électrostatiques selon un mode de réalisation.

Le dispositif 200 de la figure 2 comprend des éléments communs avec le dispositif 100 de la figure 1. Ces éléments communs ne seront pas détaillés à nouveau ci-après. Le dispositif 200 de la figure 2 diffère du dispositif 100 de la figure 1 en ce que le dispositif 200 de la figure 2 comprend n éléments capacitifs 201-1, 201-2, ... 201-n connectés respectivement en parallèle des n diodes 101-1, 101-2, ... 101-n.

Chaque élément capacitif 201-1, 201-2, ... 201-n est plus précisément un condensateur comprenant deux électrodes électriquement conductrices ou armatures, par exemple deux électrodes métalliques parallèles entre elles, séparées l'une de l'autre par un matériau diélectrique. À titre d'exemple, le dispositif 200 peut présenter une structure monolithique, chaque élément capacitif 201-1, 201-2, ... 201-n étant alors par exemple un condensateur de type MIM (de l'anglais « Metal Insulator Metal » - métal isolant métal) formé dans un empilement de niveaux électriquement conducteurs, par exemple des couches métalliques, séparés les uns des autres par des niveaux électriquement isolants, par exemple des couches diélectriques. Par ailleurs, dans le cas où le dispositif 200 est monolithique, le nœud 105 correspond par exemple à un substrat, par exemple un substrat semiconducteur, dans et sur lequel est formé le dispositif 200. Cet exemple n'est toutefois pas limitatif, le dispositif 200 pouvant, à titre de variante, être réalisé à partir de composants discrets.

Les éléments capacitifs 201-1, 201-2, ... 201-n du dispositif pseudo-bidirectionnel de protection contre des décharges électrostatiques 200 présentent par exemple des capacités sensiblement égales entre elles, aux dispersions de fabrication près. À titre d'exemple, les capacités des éléments capacitifs 201-1, 201-2, ... 201-n sont déterminées, en fonction d'une ou plusieurs fréquences d'excitation de signaux susceptibles d'être appliqués au dispositif 200 par couplage, par des outils de simulation de sorte à minimiser les harmoniques produits par le dispositif 200 à cette ou ces fréquences.

Un avantage du dispositif 200 pseudo-bidirectionnel de protection contre des décharges électrostatiques tient au fait que la présence des éléments capacitifs 201-1, 201-2, ... 201-n permet, par rapport au dispositif 100, de réduire la puissance des harmoniques.

À titre d'exemple, dans un cas où chaque diode 101-1, 101-2, ... 101-n présente une capacité égale à environ 4,5 pF, où la diode 107 présente une capacité égale à environ 38 pF et où chaque élément capacitif 201-1, 201-2, ... 201-n présente une capacité égale à environ 10 pF, des réductions de puissance des harmoniques de rang 2 d'environ -26 dB, pour une fréquence d'excitation de l'ordre de 900 MHz, d'environ -33 dB, pour une fréquence d'excitation de l'ordre de 1,75 GHz, et d'environ -37 dB, pour une fréquence d'excitation de l'ordre de 2,55 GHz, sont par exemple obtenues grâce au dispositif 200 par rapport au cas où le dispositif 100 est utilisé.

Par ailleurs, des réductions de puissance des harmoniques de rang 3 d'environ -18 dB, pour une fréquence d'excitation de l'ordre de 900 MHz, d'environ -23 dB, pour une fréquence d'excitation de l'ordre de 1,75 GHz, et d'environ -25 dB, pour une fréquence d'excitation de l'ordre de 2,55 GHz, sont par exemple obtenues grâce au dispositif 200 par rapport au dispositif 100.

La figure 3 est un schéma électrique illustrant un autre exemple de dispositif 300 de protection contre des décharges électrostatiques selon un mode de réalisation.

Le dispositif 300 de la figure 3 comprend des éléments communs avec le dispositif 200 de la figure 2. Ces éléments communs ne seront pas détaillés à nouveau ci-après. Le dispositif 300 de la figure 3 diffère du dispositif 200 de la figure 2 en ce que le dispositif 300 de la figure 3 comprend n autres éléments capacitifs 301-1, 301-2, ... 301-n reliant respectivement les bornes 103-1, 103-2, ... 103-n à la borne 109 d'application du potentiel de référence. Plus précisément, dans l'exemple illustré en figure 2, chaque élément capacitif 301-1, 301-2, ... 301-n comprend une première électrode ou borne connectée à la borne 109 d'application du potentiel de référence, et une deuxième électrode ou borne connectée à la borne 103-1, 103-2, ... 103-n correspondante. Les éléments capacitifs 301-1, 301-2, ... 301-n sont distincts des éléments capacitifs 201-1, 201-2, ... 201-n.

Le dispositif 300 comprend en outre n éléments résistifs 303-1, 303-2, ... 303-n reliant respectivement les bornes 103-1, 103-2, ... 103-n à des bornes 305-1, 305-2, ... 305-n. Les éléments résistifs 303-1, 303-2, ... 303-n sont par exemple des résistances comprenant chacune deux électrodes conductrices, par exemple des électrodes métalliques, reliées par un matériau résistif. À titre d'exemple, le dispositif 300 peut présenter une structure monolithique, chaque élément résistif 303-1, 303-2, ... 303-n étant alors par exemple formé dans un niveau électriquement conducteur, par exemple une couche métallique, de la structure. Cet exemple n'est toutefois pas limitatif, le dispositif 300 pouvant, à titre de variante, être réalisé à partir de composants discrets.

Les éléments résistifs 303-1, 303-2, ... 303-n du dispositif pseudo-bidirectionnel de protection contre des décharges électrostatiques 300 présentent par exemple des capacités sensiblement égales entre elles, aux dispersions de fabrication près.

Les bornes 305-1, 305-2, ... 305-n sont par exemple des bornes d'entrée, des bornes de sortie ou des bornes d'entrée-sortie d'un circuit intégré ou d'un composant électronique à protéger contre des décharges électrostatiques. Chaque borne 305-1, 305-2, ... 305-n est par exemple adaptée à recevoir ou émettre un signal numérique ou analogique, par exemple un signal analogique présentant une fréquence inférieure à 10 ou 20 MHz. À titre d'exemple, les bornes 305-1, 305-2, ... 305-n sont, en fonctionnement nominal, soumises à un potentiel de l'ordre de 3,3 V, de l'ordre de 5 V ou de l'ordre de 15 V.

De manière générale, le dispositif 300 comprend n branches (avec n entier supérieur ou égal à deux) comprenant chacune une diode 101 reliant la borne 103 au nœud 105, un élément capacitif 201 connecté en parallèle de la diode 101, un autre élément capacitif 301 reliant la borne 103 à la borne 109, et un élément résistif 303 reliant la borne 103 à la borne 305. Dans chaque branche du dispositif 300, l'élément résistif 303 et l'élément capacitif 301 forment un filtre RC, par exemple un filtre passe-bas.

Les éléments capacitifs 301-1, 301-2, ... 301-n du dispositif pseudo-bidirectionnel de protection contre des décharges électrostatiques 300 présentent par exemple des capacités sensiblement égales entre elles, aux dispersions de fabrication près. À titre d'exemple, les capacités des éléments capacitifs 201-1, 201-2, ... 201-n et des éléments capacitifs 301-1, 301-2, ... 301-n sont déterminées, par exemple à l'aide d'outils de simulation numérique, de sorte à ce que le dispositif 300 présente une impédance équivalente à celle d'un dispositif analogue au dispositif 300 mais qui serait dépourvu des éléments capacitifs 201-1, 201-2, ... 201-n, tout en obtenant une réduction maximale des harmoniques.

Un avantage du dispositif 300 pseudo-bidirectionnel de protection contre des décharges électrostatiques tient au fait que la présence des éléments capacitifs 201-1, 201-2, ... 201-n permet, par rapport à un dispositif analogue au dispositif 300 mais dépourvu des éléments capacitifs 201-1, 201-2, ... 201-n, de réduire la puissance des harmoniques produits.

À titre d'exemple, dans un cas où chaque diode 101-1, 101-2, ... 101-n présente une capacité égale à environ 4,5 pF, où la diode 107 présente une capacité égale à environ 38 pF, ou chaque élément capacitif 201-1, 201-2, ... 201-n présente une capacité égale à environ 35 pF, où chaque élément capacitif 301-1, 301-2, ... 301-n présente une capacité égale à environ 55 pF et où chaque élément résistif 303-1, 303-2, ... 303-n présente une résistance égale à environ 50 Ω, des réductions de puissance des harmoniques de rang 2 d'environ -42 dB, pour une fréquence d'excitation de l'ordre de 900 MHz, d'environ -38 dB, pour une fréquence d'excitation de l'ordre de 1,75 GHz, et d'environ -38 dB, pour une fréquence d'excitation de l'ordre de 2,55 GHz, sont par exemple obtenues grâce au dispositif 300 par rapport au cas où un dispositif analogue, de même impédance mais dépourvu des éléments capacitifs 201-1, 201-2, ... 201-n, est utilisé.

Par ailleurs, des réductions de puissance des harmoniques de rang 3 d'environ -9 dB, pour une fréquence d'excitation de l'ordre de 900 MHz, d'environ -11 dB, pour une fréquence d'excitation de l'ordre de 1,75 GHz, et d'environ -11 dB, pour une fréquence d'excitation de l'ordre de 2,55 GHz, sont par exemple obtenues grâce au dispositif 300 par rapport à un dispositif analogue, de même impédance, mais dépourvu des éléments capacitifs 201-1, 201-2, ... 201-n.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que la figure 3 illustre un exemple d'application dans lequel le dispositif 300 pseudo-bidirectionnel de protection contre des décharges électrostatiques met en œuvre des fonctions de filtrage, les modes de réalisation ne se limitent pas à ce type d'application mais peuvent plus généralement être mis en œuvre dans tout type de circuit intégré ou de composant électronique susceptible de tirer profit de la présence d'une protection contre des décharges électrostatiques.

Enfin, la mise en œuvre pratique des modes de réalisation et variantes décrits est à la portée de la personne du métier à partir des indications fonctionnelles données ci-dessus. En particulier, la personne du métier est capable de déterminer les valeurs des capacités intrinsèques des diodes 101-1, 101-2, ... 101-n et 107, des capacités des éléments capacitifs 201-1, 201-2, ... 201-n, des capacités des éléments capacitifs 301-1, 301-2, ... 301-n et des résistances des éléments résistifs 303-1, 303-2, ... 303-n en fonction de l'application, par exemple à l'aide d'outils de simulation numérique, afin d'optimiser la réduction des harmoniques produits par le dispositif 200 ou 300 pseudo-bidirectionnel de protection contre des décharges électrostatiques tout en permettant d'assurer des fonctions identiques ou analogues à celles d'un dispositif semblable qui serait dépourvu des éléments capacitifs 201-1, 201-2, ... 201-n.

## Revendications

1. Dispositif (200 ; 300) pseudo-bidirectionnel de protection contre des décharges électrostatiques, comprenant :
- des première et deuxième diodes (101-1, 101-2) reliant respectivement des première et deuxième bornes (103-1, 103-2) à un même nœud interne (105) du dispositif ; et
- une troisième diode (107) reliant le nœud interne (105) à une troisième borne (109) d'application d'un potentiel de référence,
**caractérisé en ce que** la troisième diode (107) présente une capacité supérieure à celle des première et deuxième diodes (101-1, 101-2), le dispositif comportant en outre des premier et deuxième éléments capacitifs (201-1, 201-2) connectés respectivement en parallèle des première et deuxième diodes (101-1, 101-2).

2. Dispositif (200 ; 300) selon la revendication 1, dans lequel :
- la première diode (101-1) comprend des électrodes d'anode et de cathode connectées respectivement au nœud interne (105) et à la première borne (103-1) ; et
- la deuxième diode (101-2) comprend des électrodes d'anode et de cathode connectées respectivement au nœud interne (105) et à la deuxième borne (103-2).

3. Dispositif (200 ; 300) selon la revendication 1 ou 2, dans lequel la troisième diode (107) comprend des électrodes d'anode et de cathode connectées respectivement au nœud interne (105) et à la troisième borne (109).

4. Dispositif (200 ; 300) selon l'une quelconque des revendications 1 à 3, dans lequel les premier et deuxième éléments capacitifs (201-1, 201-2) sont des condensateurs.

5. Dispositif (200 ; 300) selon l'une quelconque des revendications 1 à 4, dans lequel le dispositif présente une structure monolithique.

6. Dispositif (200 ; 300) selon la revendication 5, dans sa dépendance à la revendication 4, dans lequel les premier et deuxième éléments capacitifs (201-1, 201-2) sont des condensateurs MIM.

7. Dispositif (300) selon l'une quelconque des revendications 1 à 6, comprenant en outre :
- des troisième et quatrième éléments capacitifs (301-1, 301-2), distincts des premier et deuxième éléments capacitifs (201-1, 201-2), reliant respectivement les première et deuxième bornes (103-1, 103-2) à la troisième borne (109) ; et
- des premier et deuxième éléments résistifs (303-1, 303-2) reliant respectivement les première et deuxième bornes (103-1, 103-2) à des quatrième et cinquième bornes (305-1, 305-2).

8. Dispositif (300) selon la revendication 7, dans lequel :
- les troisième et quatrième éléments capacitifs (301-1, 301-2) présentent chacun une capacité égale à environ 55 pF ; et
- les premier et deuxième éléments résistifs (303-1, 303-2) présentent chacun une résistance égale à environ 50 Ω.

9. Dispositif (200 ; 300) selon l'une quelconque des revendications 1 à 8, dans lequel les première, deuxième et troisième diodes (101-1, 101-2, 107) sont des diodes Zener ou des diodes de suppression de tensions transitoires.

10. Dispositif (200 ; 300) selon l'une quelconque des revendications 1 à 9, dans lequel les premier et deuxième éléments capacitifs (201-1, 201-2) présentent des capacités sensiblement identiques entre elles.

11. Dispositif (200 ; 300) selon l'une quelconque des revendications 1 à 10, dans lequel les premier et deuxième éléments capacitifs (201-1, 201-2) présentent chacun une capacité égale à environ 10 pF.

12. Dispositif (200 ; 300) selon l'une quelconque des revendications 1 à 11, dans lequel la troisième diode (107) présente une capacité au moins deux fois supérieure, de préférence au moins cinq fois supérieure, plus préférentiellement environ dix fois supérieure à celles des première et deuxième diodes (101-1, 101-2).

13. Dispositif (200 ; 300) selon l'une quelconque des revendications 1 à 12, dans lequel :
- les première et deuxième diodes (101-1, 101-2) présentent chacune une capacité égale à environ 4,5 pF ; et
- la troisième diode (107) présente une capacité égale à environ 38 pF.

14. Dispositif (200 ; 300) selon l'une quelconque des revendications 1 à 13, dans lequel les première et deuxième bornes (103-1, 103-2) sont des bornes d'entrée et/ou de sortie d'un circuit intégré.

15. Dispositif (200 ; 300) selon l'une quelconque des revendications 1 à 14, dans lequel le nœud interne (105) correspond à un substrat semiconducteur dans et sur lequel est formé le dispositif.

## Patentansprüche

1. Pseudo-bidirektionale Vorrichtung (200; 300) zum Schutz vor elektrostatischen Entladungen, das Folgendes aufweist:
- erste und zweite Dioden (101-1, 101-2), die jeweils erste und zweite Anschlüsse (103-1, 103-2) mit einem gleichen inneren Knoten (105) der Vorrichtung koppeln; und
- eine dritte Diode (107), die den inneren Knoten (105) mit einem dritten Anschluss (109) zum Anlegen eines Referenzpotentials koppelt,
**dadurch gekennzeichnet, dass** die dritte Diode (107) eine größere Kapazität aufweist als jene der ersten und zweiten Diode (101-1, 101-2), wobei die Vorrichtung ferner ein erstes und zweites kapazitives Element (201-1, 201-2) aufweist, die jeweils parallel zu der ersten und zweiten Diode (101-1, 101-2) geschaltet sind.

2. Vorrichtung (200; 300) gemäß Anspruch 1, wobei:
- die erste Diode (101-1) Anoden- und Kathodenelektroden aufweist, die jeweils mit dem inneren Knoten (105) und mit dem ersten Anschluss (103-1) verbunden sind; und
- die zweite Diode (101-2) Anoden- und Kathodenelektroden aufweist, die jeweils mit dem inneren Knoten (105) und dem zweiten Anschluss (103-2) verbunden sind.

3. Vorrichtung (200; 300) gemäß Anspruch 1 oder 2, wobei die dritte Diode (107) Anoden- und Kathodenelektroden aufweist, die jeweils mit dem inneren Knoten (105) und mit dem dritten Anschluss (109) verbunden sind.

4. Vorrichtung (200; 300) gemäß einem der Ansprüche 1 bis 3, wobei das erste und das zweite kapazitive Element (201-1, 201-2) Kondensatoren sind.

5. Vorrichtung (200; 300) gemäß einem der Ansprüche 1 bis 4, wobei die Vorrichtung eine monolithische Struktur aufweist.

6. Vorrichtung (200; 300) gemäß Anspruch 5, und zwar in Abhängigkeit von Anspruch 4, wobei die ersten und zweiten kapazitiven Elemente (201-1, 201-2) MIM-Kondensatoren sind.

7. Vorrichtung (300) gemäß einem der Ansprüche 1 bis 6, die ferner Folgendes aufweist:
- dritte und vierte kapazitive Elemente (301-1, 301-2), die sich von den ersten und zweiten kapazitiven Elementen (201-1, 201-2) unterscheiden und jeweils die ersten und zweiten Anschlüsse (103-1, 103-2) mit dem dritten Anschluss (109) koppeln; und
- erste und zweite resistive Elemente (303-1, 303-2), die jeweils die ersten und zweiten Anschlüsse (103-1, 103-2) mit vierten und fünften Anschlüssen (305-1, 305-2) koppeln.

8. Vorrichtung (300) gemäß Anspruch 7, wobei:
- das dritte und vierte kapazitive Element (301-1, 301-2) jeweils eine Kapazität von etwa 55 pF aufweisen; und
- das erste und zweite resistive Element (303-1, 303-2) jeweils einen Widerstand von etwa 50 Ω aufweisen.

9. Vorrichtung (200; 300) gemäß einem der Ansprüche 1 bis 8, wobei die erste, zweite und dritte Diode (101-1, 101-2, 107) Zener-Dioden oder Dioden zur Unterdrückung von transienten Spannungen sind.

10. Vorrichtung (200; 300) gemäß einem der Ansprüche 1 bis 9, wobei die ersten und zweiten kapazitiven Elemente (201-1, 201-2) Kapazitäten aufweisen, die im Wesentlichen identisch zueinander sind.

11. Vorrichtung (200; 300) gemäß einem der Ansprüche 1 bis 10, wobei das erste und das zweite kapazitive Element (201-1, 201-2) jeweils eine Kapazität von etwa 10 pF aufweisen.

12. Vorrichtung (200; 300) gemäß einem der Ansprüche 1 bis 11, wobei die dritte Diode (107) eine Kapazität aufweist, die mindestens doppelt so groß, vorzugsweise mindestens fünfmal so groß und noch bevorzugter etwa zehnmal so groß ist wie jene der ersten und zweiten Dioden (101-1, 101-2).

13. Vorrichtung (200; 300) gemäß einem der Ansprüche 1 bis 12, wobei:
- die erste und zweite Diode (101-1, 101-2) jeweils eine Kapazität von etwa 4,5 pF aufweisen; und
- die dritte Diode (107) eine Kapazität von etwa 38 pF aufweist.

14. Vorrichtung (200; 300) gemäß einem der Ansprüche 1 bis 13, wobei die ersten und zweiten Anschlüsse (103-1, 103-2) Eingangs- und/oder Ausgangsanschlüsse einer integrierten Schaltung sind.

15. Vorrichtung (200; 300) gemäß einem der Ansprüche 1 bis 14, wobei der innere Knoten (105) einem Halbleitersubstrat entspricht, innerhalb dessen und auf dessen Oberseite die Vorrichtung ausgebildet ist.

## Claims

1. Pseudo-bidirectional device (200; 300) of protection against electrostatic discharges, comprising:
- first and second diodes (101-1, 101-2) respectively coupling first and second terminals (103-1, 103-2) to a same inner node (105) of the device; and
- a third diode (107) coupling the inner node (105) to a third terminal (109) of application of a reference potential,
**characterized in that** the third diode (107) has a capacitance greater than that of the first and second diodes (101-1, 101-2), the device further comprising first and second capacitive elements (201-1, 201-2) respectively connected in parallel with the first and second diodes (101-1, 101-2).

2. Device (200; 300) according to claim 1, wherein:
- the first diode (101-1) comprises anode and cathode electrodes respectively connected to the inner node (105) and to the first terminal (103-1); and
- the second diode (101-2) comprises anode and cathode electrodes respectively connected to the inner node (105) and to the second terminal (103-2).

3. Device (200; 300) according to claim 1 or 2, wherein the third diode (107) comprises anode and cathode electrodes respectively connected to the inner node (105) and to the third terminal (109).

4. Device (200; 300) according to any of claims 1 to 3, wherein the first and second capacitive elements (201-1, 201-2) are capacitors.

5. Device (200; 300) according to any of claims 1 to 4, wherein the device has a monolithic structure.

6. Device (200; 300) according to claim 5, as dependent on claim 4, wherein the first and second capacitive elements (201-1, 201-2) are MIM capacitors.

7. Device (300) according to any of claims 1 to 6, further comprising:
- third and fourth capacitive elements (301-1, 301-2), distinct from the first and second capacitive elements (201-1, 201-2), respectively coupling the first and second terminals (103-1, 103-2) to the third terminal (109); and
- first and second resistive elements (303-1, 303-2) respectively coupling the first and second terminals (103-1, 103-2) to fourth and fifth terminals (305-1, 305-2) .

8. Device (300) according to claim 7, wherein:
- the third and fourth capacitive elements (301-1, 301-2) each have capacitances equal to approximately 55 pF; and
- the first and second resistive elements (303-1, 303-2) each have resistances equal to approximately 50 Ω.

9. Device (200; 300) according to any of claims 1 to 8, wherein the first, second, and third diodes (101-1, 101-2, 107) are Zener diodes or transient voltage suppression diodes.

10. Device (200; 300) according to any of claims 1 to 9, wherein the first and second capacitive elements (201-1, 201-2) have capacitances substantially identical to one another.

11. Device (200; 300) according to any of claims 1 to 10, wherein the first and second capacitive elements (201-1, 201-2) each have a capacitance equal to approximately 10 pF.

12. Device (200; 300) according to any of claims 1 to 11, wherein the third diode (107) has a capacitance at least twice greater, preferably at least five times greater, more preferably approximately ten times greater, than those of the first and second diodes (101-1, 101-2).

13. Device (200; 300) according to any of claims 1 to 12, wherein:
- the first and second diodes (101-1, 101-2) each have a capacitance equal to approximately 4,5 pF; and
- the third diode (107) has a capacitance equal to approximately 38 pF.

14. Device (200; 300) according to any of claims 1 to 13, wherein the first and second terminals (103-1, 103-2) are input and/or output terminals of an integrated circuit.

15. Device (200; 300) according to any of claims 1 to 14, wherein the inner node (105) corresponds to a semiconductor substrate inside and on top of which is formed the device.
